Europäisches Patentamt

European Patent Office

Office européen des brevets

(11) Publication number: **0 023 735**
**A1**

# EUROPEAN PATENT APPLICATION

(21) Application number: **80200688.2**

(22) Date of filing: **15.07.80**

(51) Int. Cl.³: **G 01 R  25/00, H 03 H  7/40**

(30) Priority: **25.07.79  GB 7925900**

(43) Date of publication of application: **11.02.81**
**Bulletin 81/6**

(84) Designated Contracting States: **DE FR GB IT NL SE**

(71) Applicant: **PHILIPS ELECTRONIC AND ASSOCIATED INDUSTRIES LIMITED, Abacus House 33 Gutter Lane, London EC2V 8AH (GB)**

(84) Designated Contracting States: **GB**

(71) Applicant: **N.V. Philips' Gloeilampenfabrieken, Pieter Zeemanstraat 6, NL-5621 CT Eindhoven (NL)**

(84) Designated Contracting States: **DE FR IT NL SE**

(72) Inventor: **Underhill, Michael James, PHILIPS RESEARCH LABORATORIES, Redhill Surrey, RH1 5HA (GB)**

(74) Representative: **Boxall, Robin John et al, Philips Electronic and Associated Ind. Ltd. Patent Department Mullard House Torrington Place, London WC1E 7HD (GB)**

(54) Circuit arrangement for comparing two alternating voltages of the same frequency.

(57)  A circuit arrangement for use as a phase, resistance, or conductance discriminator in, for example, an automatic load matching unit such as an aerial tuning unit. The arrangement employs two diodes (D1, D2) in a two-terminal-pair-network, which diodes rectify voltages derived from two input voltages A and B to produce an output voltage $V_o$ which is a function of both input voltages and is indicative, for example, of the difference in phase or modulus of the input voltages. The rectified voltages produced by the respective diodes can be combined, by suitable choice of components, in such a way that any non-linearity produced by one diode is exactly offset by the same non-linearity produced by the other diode.

25.6.80          1          PHB 32669

CIRCUIT ARRANGEMENT FOR COMPARING TWO ALTERNATING VOLTAGES
OF THE SAME FREQUENCY.

The invention relates to a circuit arrangement for comparing two alternating voltages of the same frequency, comprising a two-terminal-pair network which, at the operational frequency, comprises components of negligible reactance; which network further includes a first and a second diode.

An arrangement of the type defined above is known and has been used, for example, as a phase discriminator. One known form of discriminator comprises two transformers for respectively applying the two voltages to the diodes, one of the transformers having a centre-tapped secondary winding and both transformers having secondary windings which float with respect to ground potential. For satisfactory operation, the voltages applied to the diodes must, of course, be very considerably larger than the knee voltage of the diodes and the use of transformers enables the input voltages to be transformed to an appropriately high level, even if they have an input level below the said knee voltage. The use of transformers, however, leads to several disadvantages; namely (1) the output signal is floating with respect to ground potential, (2) it is difficult to provide transformers having negligible reactance at high operating frequencies and, hence, the frequency range over which the phase detector can work is severely limited, and (3) transformers are relatively large and expensive compared with other passive components such as diodes, resistors and capacitors.

United Kingdom Patent Specification No. 971,903 discloses a phase discriminator of the type defined which at least mitigates these disadvantages to the extent that it enables a single-ended output (i.e. not floating with respect to ground) to be provided. The disclosed discriminator has the form of a bridged-T network in which each series arm is formed by a respective resistance, the bridge arm is formed by one of the two diodes, and the shunt arm is formed by the other diode. The rectified voltages in the network are isolated from the input alternating voltages by respective DC-blocking capacitors in the inputs to the two series arms. A disadvantage of this phase discriminator however, is that voltage amplifiers, for example transformers, have to be used if the input signal levels are not considerably greater than the diode knee voltage. Some of the disadvantages resulting from the use of transformers can be mitigated by the use of active (for example transistorised) voltage amplifiers but then the inherent advantages, for example the low cost and simplicity, of a passive network are lost.

Phase discriminators are used *inter alia* in automatic impedance matching systems in which the impedance of a load (for example an antenna) is automatically matched to the impedance of a source (for example a radio transciever) by means of an adjustable reactance between the source and load. The reactance is adjusted, for example by motors in a servo loop system, until the source and load impedances are matched, the motors being controlled by output signals from discriminators which, in effect, monitor the aerial-plus-reactance impedance as seen by the source. These output signals are used to vary the reactance until the source and load impedances are matched.

One such system is described, for example, in United Kingdom Patent Specification No 881,018, which system uses a phase discriminator and also a modulus, or resistance, discriminator. In general, a resistance discriminator provides a voltage whose polarity varies according as the ratio of the load impedance $R_L$ of the feeder to the characteristic impedance $R_o$ of the feeder is greater or less than unity and has a null point when the load impedance is equal to the characteristic impedance.

0023735

United Kingdom Patent Specification No.1,412,314 discloses a system in which, in one mode of operation, a resistance discriminator and a conductance discriminator are used to provide the required servo signals. In an alternative mode, a phase discriminator is used instead of the resistance discriminator.

In each of the automatic load adjusting systems the input signals to the, or each, discriminator comprise an alternating voltage which is proportional to the voltage V on the transmission line at a particular point and an alternating voltage which is proportional to the current I in the line at that point. The latter voltage is, for example, generated across a resistor which shunts the secondary winding of a current transformer in the transmission line.

It is the object of the invention to provide a circuit arrangement of the 'double diode' type defined above which can be used as a phase discriminator in which the above-mentioned disadvantages (1) to (3) are at least mitigated and which can also be used as either a resistance or a conductance discriminator.

Accordingly the invention provides a circuit arrangement for comparing two alternating voltages of the same frequency, comprising a two-terminal-pair network which, at the operational frequency, comprises components of negligible reactance; which network further includes a first and a second diode, wherein the network is in the form of a π network and comprises:-

a first sub-network bridging at least part of the series arm of the π network and including said first diode for deriving a first direct voltage which is a function of the alternating voltage applied across a first terminal pair of the network and which is also a function of the alternating voltage applied across the second terminal pair,

a second sub-network connected in parallel with at least part of a shunt arm of the π network and including said second diode for deriving a second direct voltage which is a function of the alternating voltage applied across the second terminal pair, and means for combining the first and second direct voltages to provide a third direct voltage which is indicative of the difference
between a parameter of the alternating voltage applied across the
first terminal pair and the same parameter of the alternating voltage
applied across the second terminal pair.

It will be shown, in the subsequent description of embodiments
of arrangements according to the invention, that the effects of the
knee voltages of the diodes precisely cancel each other and, hence,
the arrangement can be used with input signals lower than the diode
knee voltage. Further, no transformer is required and the
arrangement retains the advantage that the output signals are
single-ended.

A first embodiment of an arrangement according to the invention,
for use as a phase discriminator, is characterised in that said
difference between the same parameters of the two alternating voltages
is their phase difference, the series arm of the π network
includes a first and a second resistance arranged in series between
the shunt arms, the second resistance is shunted by the first diode,
the second diode is connected to the junction of the first and
second resistances in parallel with the shunt arms of the network,
a first of the two shunt arms of the π network comprises a third
resistance, and the second of the two shunt arms comprises a series
arrangement of a fourth resistance and a first capacitance with the
fourth resistance connected to the series arm, said first
capacitance having a negligible reactance at the operational
frequency, the two diodes being so connected that a pole of one is
connected to the like pole of the other, and the junction of the
fourth resistance and first capacitance constitutes the output
signal point of the arrangement.

In an embodiment of such a phase discriminator, the first diode
also shunts a fifth resistance connected in the series arm in series
with the second resistance, said fifth resistance being shunted by a
second capacitor having a negligible reactance at the operational
frequency. The fifth resistance can be used to adjust the DC load on
the first diode without affecting the AC load since it is shunted by
the negligible impedance of the second capacitor.

Preferably, in the last mentioned embodiment, the resistance values of the first and second resistances are equal and wherein the resistance values of the third, fourth and fifth resistances are equal. Such an arrangement equates the DC loads on the two diodes so that, if originally a matched pair, they have the same characteristic performance in operation and thereby eliminates any distortion that might otherwise be caused by their having different loads. It also provides the same input impedance at each terminal pair, assuming the source impedances are equal.

A further embodiment of a circuit arrangement according to the invention, which can be used as a resistance or conductance discriminator, is characterised in that the said difference between the same parameters of the two alternating voltages is the difference between their moduli, the series arm of the $\pi$ network comprises a first resistor arranged between the shunt arms, a first of the two shunt arms of the $\pi$ network comprises a series arrangement of a second, a third and a fourth resistance with the second resistance at the series arm end of the series arrangement, a first capacitor having a negligible reactance at the operational frequency being connected across the fourth resistance, the first diode is connected across the first and second resistance, the second diode is connected across the third and fourth resistances with one pole thereof connected to the like the first diode, the second of the two shunt arms comprises a fifth resistor and a second capacitor in series, the fifth resistor being the nearer to the series arm of the $\pi$ network, and the junction of the fifth resistor and second capacitor constitutes the output signal point of the arrangement. The arrangement acts as a resistance or a conductance discriminator in dependence upon which input alternating voltage is connected to which terminal pair. Preferably, the resistance values of the first and fourth resistances are equal, the resistance values of the second and third resistances are equal, and the resistance value of the fifth resistance is twice that of the second resistance. This has the advantages that the DC loads on the two diodes are equal and that the input impedances are equal if the source impedances are equal.

0023735

If the input sources are not DC-isolated, a respective DC-blocking capacitor is included between the $\pi$ network and each terminal connected to the series arm of the $\pi$ network, these capacitors having negligible reactance at the operational frequency. The DC-blocking capacitors ensure that the sources do not shunt the DC voltages provided by the diodes.

Embodiments of the invention will now be described, by way of example, with reference to the accompanying drawing, of which:

Figure 1 is a circuit diagram of an embodiment of a circuit arrangement according to the invention for use as a phase discriminator, and

Figure 2 is a circuit diagram of an embodiment of a circuit arrangement according to the invention for use as a resistance or conductance discriminator.

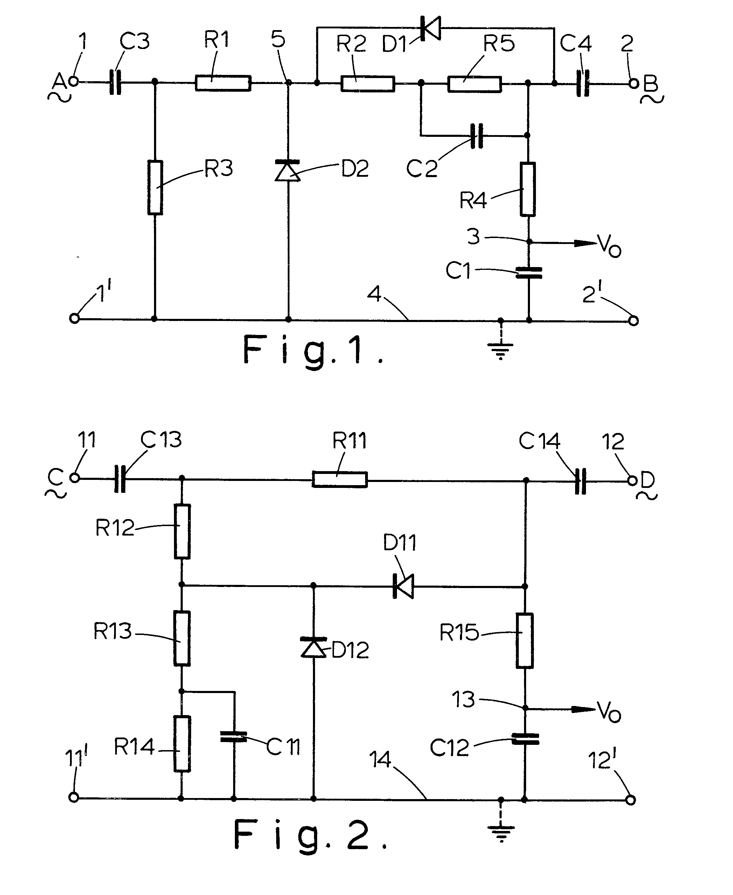

Figure 1 shows a circuit arrangement according to the invention which operates as a passive phase discriminator and comprises a first terminal pair 1,1', a second terminal pair 2,2', five resistances R1 to R5, two diodes D1 and D2, and four capacitors C1 to C4 each of which has a negligible reactance at the operational frequency of the arrangement. Thus under AC conditions, the capacitors are effectively short circuits and the arrangement comprises a substantially resistive $\pi$ network in which resistances R1 and R2 constitute the series arm and each of resistances R3 and R4 constitutes a respective shunt arm. Under DC conditions, capacitors C1 to C4 are DC-blocking capacitors and, hence, resistance R5 is not short-circuited and, with resistance R2, forms the DC load on diode D1. The DC load on diode D2 comprises the resistances R1 and R2. Capacitor C1 isolates a DC output voltage (Vo), appearing at circuit point 3, from the common circuit rail 4 which interconnects terminals 1' and 2'. Capacitors C3 and C4 are DC-blocking capacitors so that DC voltages provided by the diodes D1 and D2 are not affected by any DC path that may be present in the input signal sources to the two terminal pairs. These two capacitors may be omitted if there are no such paths.

0023735

In the above-described manner, diode D1 constitutes the above-mentioned first sub-network which bridges the part R2-R5 of the series arm comprising resistances R1-R2-R5, and diode D2 constitutes the second sub-network which is in parallel with a shunt arm (R3) of the network.

For the purposes of explaining the operation of the circuit shown in Figure 1, it will be assumed that the common rail 4 is at zero voltage, for example ground, an AC voltage $\underset{\sim}{A}$ is applied to terminal 1, and an AC voltage $\underset{\sim}{B}$ is applied to terminal 2. For convenience of explanation, it will also be assumed that $\underset{\sim}{A} > \underset{\sim}{B}$. The resistance values of resistances R1 to R5 are so chosen that R1=R2 and R3=R4=R5.

Under AC conditions, resistance R5 is short-circuited by capacitor C2 and capacitor C1 is effectively a short circuit. Since R1=R2 and R3=R4, the network is balanced about circuit point 5 under these conditions and the AC voltage across resistance R2, and hence across diode D1, is therefore half the difference between voltages $\underset{\sim}{A}$ and $\underset{\sim}{B}$, namely $\frac{1}{2}|\underset{\sim}{A}-\underset{\sim}{B}|$. Similarly, due to the balance, the voltage between point 5 and rail 4, and hence across diode D2, is the mean of voltages $\underset{\sim}{A}$ and $\underset{\sim}{B}$, namely $\frac{1}{2}|\underset{\sim}{A}+\underset{\sim}{B}|$. These two voltages are converted to a respective DC voltages by diodes D1 and D2 and are combined at point 5. Since both diodes are poled towards point 5, the voltage Vo at output terminal 3 is $\frac{1}{2}|\underset{\sim}{A}+\underset{\sim}{B}| - \frac{1}{2}|\underset{\sim}{A}-\underset{\sim}{B}|$, this voltage being isolated from the rail 4 by capacitor C1. If the phase angle between the vectors of $\underset{\sim}{A}$ and $\underset{\sim}{B}$ is $\beta$, then $2Vo = (A^2 + B^2 + 2ABcos\beta)^{\frac{1}{2}} - (A^2 + B^2 - 2ABcos\beta)^{\frac{1}{2}}$.

Thus if $0 < \beta < \pi/2$ then cos $\beta$, and hence Vo, is positive;
if $\pi/2 < \beta < 3\pi/2$ then cos $\beta$, and hence Vo, is negative;
if $3\pi/2 < \beta < 2\pi$ then cos $\beta$, and hence Vo, is positive; and
if $\beta = \pm\pi/2$, i.e. $\underset{\sim}{A}$ and $\underset{\sim}{B}$ are in phase quadrature, then cos $\beta = 1$, Vo = 0.

Thus the voltage Vo has a null point at $\beta = 90°$ and $\beta = 270°$, and is a function of the phase difference between signals $\underset{\sim}{A}$ and $\underset{\sim}{B}$; i.e. the circuit arrangement operates as a phase discriminator irrespective of the amplitudes of the input voltages. If either one of the input voltages is much larger than the other and also much larger than the
knee voltage of the diodes, then the larger of the two will
act as a reference input and the discriminator will then provide
conventional synchronous detection of the smaller amplitude input.
The equal values and the positioning of resistances R1 and R2 provide
equal voltages across the two diodes either under phase quadrature
conditions or when one input is much larger than the other.

The choice of value and
the positioning of resistance R1 and resistance R5 ensures that the DC
loads on the two diodes are equal. Thus, when the AC voltages across
the two diodes are equal, the mean DC currents in the diodes are equal
and, since they have opposite signs, the effects of the diode knee
characteristics are equal and subtract perfectly at the output. For
this reason, a phase discriminator embodying the invention can be used
with input signal voltages that are very much lower than those
required for the satisfactory operation of the prior art phase detector
described above, i.e. they can be less than the diode knee voltage.

Further the equating of the resistance values of resistors R3 and
R4 ensures that the AC loads on the sources of $\underset{\sim}{A}$ and $\underset{\sim}{B}$ are equal,
assuming that the source impedances of $\underset{\sim}{A}$ and $\underset{\sim}{B}$ are equal.

In a practical embodiment of a phase discriminator as shown in
Figure 1, the operational frequency range was 1.5 to 30MHz and the various
components had the following values:

R1, R2                    1    kohm

R3, R4, R5                100 kohm

C1 to C4                  0.1 μF

With a slight rearrangement of the inputs of the circuit shown
in Figure 1, a circuit arrangement according to the invention can
serve as a resistance or a conductance discriminator, and embodiment
of which is shown in Figure 2.

The circuit shown in Figure 2 comprises a first terminal pair 11,
11', a second terminal pair 12, 12', five resistances R11 to R15,
two diodes D11, D12, and four capacitors C11 to C14 each of which
has negligible reactance at the operational frequency of the
arrangement. Thus under AC conditions the capacitors are effectively short circuits and the arrangement comprises a substantially resistive
π network in which resistance R11 constitutes the series arm,
resistances R2, R3 and R4 constitute one shunt arm and resistance
R15 constitutes the other series arm. Under DC conditions, capacitors
C11 to C14 are DC-blocking capacitors. The DC load on diode D1
therefore comprises resistances R11, R12 and the DC load on diode
D2 comprises resistances R13, R14. Capacitor C2 isolates a DC
output voltage (Vo), appearing at circuit point 13, from the
common circuit rail 14 which interconnects terminals 11' and 12'.
Capacitors C13 and C14 prevent DC voltages provided by diodes D11 and
D12 from being affected by any DC path that may be present in the
input signal sources to the terminal pairs. These two capacitors
may be omitted if there are no such paths.

In the above-described manner, diode D11 constitutes the
above-mentioned first sub-network which bridges, in this case, the
whole of the series arm (R11) and diode DC constitutes the second
sub-network which is in parallel with the part R13, R14 of the
shunt arm comprising resistances R12, R13, R14.

For the purposes of explaining the operation of the circuit shown
in Figure 2, it will be assumed that the circuit rail 4 is at zero
voltage, for example ground, an AC voltage $\underset{\sim}{C}$ is applied to
terminal 11, and an AC voltage D is applied to terminal 12. For
convenience, it will also be assumed that $\underset{\sim}{C} > \underset{\sim}{D}$. The resistance values
of resistances R11 to R15 are such that R11=R14, R12=R13, and R15=2R12.

Under AC conditions, resistance R14 is short-circuit
C11 and capacitor C12 is effectively a short circuit. Since, in
terms of their resistance values, R12+R13 = R15, the input
impedances at the terminal pairs 11, 11' and 12, 12' are equal,
assuming that the impedances of the sources of voltage $\underset{\sim}{C}$ and $\underset{\sim}{D}$ are
equal. Further, in terms of their resistance values, R11 + R12 =
R13 + R14 and so the DC loads on diodes D11 and D12 are equal.

The operation of the circuit shown in Figure 2 is as follows.
Under AC conditions, the voltage across resistance R13 is the same
as that across resistance R12 (since resistance R14 is short-
circuited by capacitor C11) and, hence, is equal to $\frac{1}{2}\underset{\sim}{C}$, this voltage

being rectified by diode D12 to produce a voltage $+\frac{1}{2}|C|$ at the junction of the two diodes. The AC voltage across diode D11 comprises a voltage $\underset{\sim}{C} - \underset{\sim}{D}$ across resistance R11 and a voltage $\frac{1}{2}\underset{\sim}{C}$ across resistor 12, and so the combined voltage is $\underset{\sim}{C} - \underset{\sim}{D} - \frac{1}{2}\underset{\sim}{C}$. This voltage is rectified by diode D12 to produce a voltage $|\underset{\sim}{C} - \underset{\sim}{D}| - \frac{1}{2}|\underset{\sim}{C}|$. The DC voltage Vo appearing at circuit output point 13 is the series combination of the two voltages across the diodes having regard to their sign, i.e. Vo $= \frac{1}{2}|\underset{\sim}{C}| - \frac{1}{2}|\underset{\sim}{C} - 2\underset{\sim}{D}|$. This output signal can be used to control a matching network to adjust a load impedance to equal a source impedance.

Resistance discriminators are, for example, used in the manner described above to measure the ratio between a source impedance $R_o$ and a load impedance $R_L$ and produce an output signal $V_o$ which is a function of the ratio and is used to adjust $R_L$ to equal $R_o$, i.e. to match the load to the source. If the voltage and current in a transmission line between source and load are V and I respectively, then $R_L = V/I$. In Figure 2, the voltages $\underset{\sim}{C}$ and $\underset{\sim}{D}$ are assumed to be derived from V and I such that $\underset{\sim}{C} = \underline{c}V$ and $\underset{\sim}{D} = \underline{c}'I$ where $\underline{c}$ and $\underline{c}'$ are constants if proportionality (scaling factors). As we are concerned with the ratio $R_L/R_o$, the equations can be normalised by putting $R_o = 1$. Also, $R_L = \underset{\sim}{C}/\underset{\sim}{D}$, whence $\underset{\sim}{C} = \underset{\sim}{D}R_L$. If the angle between the vectors of $\underset{\sim}{C}$ and $\underset{\sim}{D}$ is $\theta$, then

$$|\underset{\sim}{C} - 2\underset{\sim}{D}| = (C^2 + 4D^2 - 4CD \cos \theta)^{\frac{1}{2}}$$

Since magnitude (not phase) is being measured, put $\cos\theta=1$ (i.e. $\theta=0$) Then, from the above expression for $V_o$

$$2V_o = |\underset{\sim}{C}| - |\underset{\sim}{C} - 2\underset{\sim}{D}| = C - (C^2 + 4D^2 - 4CD)^{\frac{1}{2}}$$

Substituting $DR_L$ for C

$$2V_o = DR_L - (D^2R_L{}^2 + 4D^2 + 4D^2R_L)^{\frac{1}{2}}$$
$$= D\left\{R_L - (R_L{}^2 + 4 + 4R_L)^{\frac{1}{2}}\right\}$$

Thus $V_o$ is proportional to $R_L - (x)^{\frac{1}{2}}$ where $x = R_L{}^2 + 4 + 4R_L$.

If $R_L < 1$, then $(x)^{\frac{1}{2}} > R_L$ and $V_o$ is negative.

If $R_L = 1$, then $(x)^{\frac{1}{2}} = R_L$ and $V_o$ is zero.

If $R_L > 1$, then $(x)^{\frac{1}{2}} < R_L$ and $V_o$ is positive.

Thus the output signal of the resistance discriminator is a function of the ratio $R_L/R_o$ and can be used to adjust $R_L$ to equal $R_o$.

If the inputs to the discriminator are reversed such that C = $\underline{c}'$I and D = $\underline{c}$V, then the discriminator functions as a conductance discriminator.

In a practical embodiment of a resistance/conductance discriminator as shown in Figure 2, the operational frequency range was 1.5 to 30 MHz and the various components had the following values:-

| R11, R14 | 47 kohm |
| R12, R13 | 10 kohm |
| R15 | 20 kohm |
| C1 to C4 | 0.1 μF |

CLAIMS:

1.  A circuit arrangement for comparing two alternating voltages of the same frequency, comprising a two-terminal-pair network which, at the operational frequency, comprises components of negligible reactance; which network further includes a first and a second diode, wherein the network is in the form of a π network and comprises:-

a first sub-network bridging at least part of the series arm of the π network and including said first diode for deriving a first direct voltage which is a function of the alternating voltage applied across a first terminal pair of the network and which is also a function of the alternating voltage applied across the second terminal pair,

a second sub-network connected in parallel with at least part of a shunt arm of the π network and including said second diode for deriving a second direct voltage which is a function of the alternating voltage applied across the second terminal pair, and means for combining the first and second direct voltages to provide a third direct voltage which is indicative of the difference between a parameter of the alternating voltage applied across the first terminal pair and the same parameter of the alternating voltage applied across the second terminal pair.

2.  A circuit arrangement as claimed in Claim 1, wherein said difference between the same parameters of the two alternating voltages is their phase difference, the series arm of the π network includes a first and a second resistance arranged in series between the shunt arms, the second resistance is shunted by the first diode, the second diode is connected to the junction of the first and second resistances in parallel with the shunt arms of the network, a first of the two shunt arms of the π network comprises a third resistance, and the second of the two shunt arms comprises a series arrangement of a fourth resistance and a first capacitance with the fourth resistance connected to the series arm, said first capacitance having a negligible reactance at the operational frequency, the two diodes being so connected that a pole of one is connected to the like pole of the other, and the junction of the fourth resistance and first capacitance constitutes the output signal point of the arrangement.

3. A circuit arrangement as claimed in Claim 2, wherein the first diode also shunts a fifth resistance connected in the series arm in series with the second resistance, said fifth resistance being shunted by a second capacitor having a negligible reactance at the operational frequency.

4. A circuit arrangement as claimed in Claim 3 wherein the resistance values of the first and second resistances are equal and wherein the resistance values of the third, fourth, and fifth resistances are equal.

5. A circuit arrangement as claimed in Claim 1, wherein said difference between the same parameters of the two alternating voltages is the difference between their moduli, the series arm of the π network comprises a first resistor arranged between the shunt arms, a first of the two shunt arms of the π network comprises a series arrangement of a second, a third, and a fourth resistance with the second resistance at the series arm end of the series arrangement, a first capacitor having a negligible reactance at the operational frequency being connected across the fourth resistance, the first diode is connected across the first and second resistance, the second diode is connected across the third and fourth resistances with one pole thereof connected to the like pole of the first diode, the second of the two shunt arms comprises a fifth resistor and a second capacitor in series, the fifth resistor being the nearer to the series arm of the π network, and the junction of the fifth resistor and second capacitor constitutes the output signal point of the arrangement.

6. A circuit arrangement as claimed in Claim 5, wherein the resistance values of the first and fourth resistances are equal, the resistance values of the second and third resistances are equal, and the resistance value of the fifth resistance is twice that of the second resistance.

7. A circuit arrangement as claimed in any previous Claim, wherein a respective DC-blocking capacitor is included between the π network and each terminal connected to the series arm of the π network, these capacitors having negligible reactance at the operational frequency.

0023735

1/1

**Fig.1.**

**Fig.2.**

PHB 32669

European Patent
Office

EUROPEAN SEARCH REPORT

0023735

Application number

EP 80 20 0688.2

## DOCUMENTS CONSIDERED TO BE RELEVANT

| Category | Citation of document with indication, where appropriate, of relevant passages | Relevant to claim |
|---|---|---|
| | US − A − 2 911 593 (J. CAUCHOIS et al.) <br> * fig. 1 to 7 * <br> −− | 1 |
| | US − A − 2 640 939 (L. STASCHOVER et al.) <br> * fig. 1 to 7 * <br> −− | 1,2 |
| D,A | GB − A − 881 018 (TELECOMMUNICATIONS RADIOELECTRIQUES ET TELEPHONIQUES) <br> * fig. 1 to 5 * <br> −− | |
| D,A | GB − A − 971 903 (ELECTRIC & MUSICAL INDUSTRIES LTD.) <br> * fig. 1 to 8 * <br> −− | |
| A | DE − C − 1 015 144 (MARCONI'S WIRELESS TELEGRAPH CO.) <br> * fig. 1 to 8 * <br> −− | |
| A | US − A − 3 922 679 (D.V. CAMPBELL) <br> * fig. 1 * <br> −−−− | |

**CLASSIFICATION OF THE APPLICATION (Int. Cl.3)**

G 01 R 25/00

H 03 H 7/40

**TECHNICAL FIELDS SEARCHED (Int.Cl.3)**

G 01 R 25/00

H 03 D 13/00

H 03 H 7/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

X

The present search report has been drawn up for all claims

| Place of search <br> Berlin | Date of completion of the search <br> 28−10−1980 | Examiner <br> BREUSING |
|---|---|---|

EPO Form 1503.1 06.78